# EUROPEAN PATENT SPECIFICATION

(11) **EP 1 522 895 B1**
(45) Date of publication and mention of the grant of the patent: **02.11.2006**
(21) Application number: 04077690.8
(22) Date of filing: 29.09.2004
(51) Int. Cl.: G03F 7/20

(54) **Method of and apparatus for supplying a dynamic protective layer to a mirror**
Verfahren und Gerät zur Herstellung einer Schutzschicht auf einem Spiegel
Procédé et appareil de formation d'une couche protectrice sur un miroir

(30) Priority: 06.10.2003 EP 03078140
(43) Date of publication of application: 13.04.2005
(73) Proprietor: ASML Netherlands B.V., 5504 DR Veldhoven (NL)
(72) Inventor: Banine, Vadim Yevgenyevich, 5704 NK Helmond (NL); Bakker, Levinus Pieter, 5708 ZT Helmond (NL)
(74) Representative: van Westenbrugge, Andries

(56) References cited:
- EP-A- 1 186 957
- EP-A- 1 204 002

## Description

The present invention relates to a method of supplying a dynamic protective layer to at least one mirror to protect the at least one mirror from etching by ions, the method comprising
- supplying a gaseous matter to a chamber containing the at least one mirror,
- monitoring reflectivity of the mirror.

The invention further relates to a device manufacturing method and an apparatus for supplying a dynamic protective layer to a mirror. Also the invention relates to a lithographic projection apparatus, comprising:
- a radiation system for providing a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In the case of this invention, the projection system will generally consist of an array of mirrors, and the mask will be reflective. The radiation in this case is preferably electromagnetic radiation in the extreme ultraviolet (EUV) range. Typically, the radiation has a wavelength below 50 nm, but preferably below 15 nm, for instance 13.7 or 11 nm. The source of EUV radiation is typically a plasma source, for example a laser-produced plasma or a discharge source. The laser-produced plasma source may comprise water droplets, xenon, tin or a solid target which is irradiated by a laser to generate EUV radiation.

A common feature of any plasma source is the inherent production of fast ions and atoms, which are expelled from the plasma in all directions. These particles can be damaging to the collector and condensor mirrors which are generally multilayer mirrors, with fragile surfaces. This surface is gradually degraded due to the impact, or sputtering, of the particles expelled from the plasma and the lifetime of the mirrors is thus decreased. The surface of the mirror is further degraded by oxidation.

A measure which has previously been used and which does address the problem of damage to the mirrors, is to reduce the impact of the particle flux on the mirrors using a background gas of helium to impede the particles by collisions. However, this type of technique cannot reduce the sputtering rate to an acceptable level whilst keeping the background pressure of, for instance, helium low enough to ensure sufficient transparency to the radiation beam.

EP 1 186 957 A2 describes a method and apparatus for solving this problem by providing gas supply means for supplying a gaseous hydrocarbon to a space containing a mirror (i.e. collector) and a reflectivity sensor that measures the sensitivity of the mirror. Further on, the pressure is measured by a pressure sensor. The introduction of hydrocarbon molecules in the chamber containing mirrors will lead to a hydrocarbon protective layer forming on the surface of the mirrors. This protective layer protects the mirror from chemical attack, such as oxidation and sputtering, but also decreases the reflectivity of the mirror.

The protective layer is gradually destroyed by sputtering and once it is has been eroded, damage to the mirror surface will occur. Therefore, it is advantageously to apply a protective layer that is not too thin. Secondly, if the protective layer is too thick, the reflectivity of the mirror is decreased to an unacceptable level and the efficiency of the projection apparatus is reduced.

The invention described in EP 1 186 957 A2 solves this problem by creating a dynamic protective layer. The growing speed of the protective layer can be regulated by varying the gas pressure of the hydrocarbon. If the protective layer becomes too thick, the pressure is decreased and if the protective layer becomes to thin, the pressure is increased. By balancing the growth and the decline of the protective layer, a desired thickness can be maintained. Information about the thickness of the protective layer can be deduced from the reflectivity sensor.

It will be understood that preferably only the collector, i.e. the mirror that first receives the light and fast ions coming from the plasma source, will have to be protected using such a dynamic protective layer. The following mirrors are not subjected to these fast ions coming from the plasma source.

However, it has been discovered that the EUV radiation induces a plasma, comprising positive ions and electrons in the chamber containing the mirrors. Both the ions and electrons can be absorbed by the surface of the mirror, but since the electrons are quicker than the positive ions, an electric field will arise in the vicinity of the mirror surface, typically over a distance corresponding to the length, which can be defined as the maximum distance in which concentrations of electrons and ions differ sensibly, causing a local violation of the electrical quasi-neutrality. This phenomena is known to a person skilled in art.

As a result of this electric field, the ions will be accelerated in the direction of the mirror surface, causing etching or sputtering, degenerating the mirror surface. This effect is called plasma-induced etching. Plasma-induced etching occurs not only at the condenser mirrors, but also at the further mirrors.

It will be understood that the method of establishing a dynamic protective layer as described with reference to EP 1 186 957 is not applicable for the further mirrors, since, there, no fast ions are coming from the source. Further on, increasing the pressure will not only result in a thicker protective layer, but will also increase the plasma-induced etching. Also, since different mirrors are not subjected to the same sputtering conditions, a separate gas supply and gas chamber would have to be provided for each mirror which is not practical. Therefore it is an object of the present invention to provide an alternative apparatus and method to protect the mirrors of the projection apparatus against plasma-induced etching and oxidation.

This is achieved according to the invention as specified in the opening paragraph, characterized in that the thickness of the protective layer is controlled by controlling a potential of the surface of the mirror, based on the monitored reflectivity of the mirror. By controlling the potential of the surface of the mirror, the etching process of the mirror surface can be controlled. Since etching is caused by positive ions that are attracted to the surface of the mirror, adjusting the potential thereof, controls the impact velocity of the atoms, and thus, the effectiveness of the etching.

The use of such a dynamic protective layer prevents mirror etching due to plasma-induced etching. By controlling the amount of growth and etching of the protective layer, the thickness of the protective layer can be controlled. This makes it possible to create a protective layer that has a certain desired thickness that protects the mirror from etching and does not reduce the reflectivity of the mirror too much. The protective layer further effectively protects the mirror against oxidation.

According to a preferred embodiment of the invention, the gas is a gaseous hydrocarbon (HₓC_{y}), such as acetic anhydride, n-amyl alcohol, amyl benzoate, diethylene glycol ethyl ether, acrylic acid, adipic acid, 2-tert-butyl-4-ethylphenol. These gases are well suited to form a protective layer.

According to a further preferred embodiment of the invention, the at least one mirror is used to image a mask to a substrate. The invention can advantageously be used in a lithographic projection apparatus. Such an lithographic projection apparatus images a projection beam from patterning means, such as a mask, to a substrate. Since the imaged pattern is usually very fine, the optics used in such a lithographic projection apparatus need to be protected from any damaging processes. Even a relatively small defect on the mirror surface, could cause a defect in the produced substrate.

According to a further preferred embodiment of the invention, the at least one mirror is used to project an EUV radiation beam. The invention can advantageously be used in applications using EUV radiation. It has been discovered that EUV radiation may generate a plasma in front of a mirror. As discussed above, such a plasma will result in an electric field in the vicinity of the mirror, causing positive ions to etch the surface of the mirror. EUV applications are particular sensitive to defects on the mirror, since EUV radiation is usually used to project relatively very fine patterns from a mask to a substrate. Also, reflecting EUV radiation is difficult anyway.

According to a further preferred embodiment of the invention, the chamber has a background pressure that is monitored. This enables to control the amount of gas in the chamber, and thus the growing speed of the protective layer, in a more accurate way.

According to a further aspect of the invention, the invention relates to a device manufacturing method comprising:
- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material,
characterized by applying the method according to the invention.

According to a further aspect of the invention, the invention relates to an apparatus for supplying a dynamic protective layer to at least one mirror to protect the at least one mirror from etching by ions, the apparatus comprising a chamber with the at least one mirror, an inlet for supplying a gaseous matter to the chamber containing the at least one mirror and means for monitoring reflectivity of the mirror,
characterized in that, the apparatus further comprises a controllable voltage source for applying a potential to the surface of the mirror in order to control the thickness of the protective layer in dependence on said reflectivity of said mirror. The apparatus as here described is arranged to supply a protective layer to the surface of the mirror by enabling a gaseous matter to enter the chamber. The gaseous matter will precipitate on the mirror surface, forming a protective layer. The etching process, dominated by positive ions, can be controlled by controlling the potential of the mirror surface by controlling the controllable voltage source. By doing that, a dynamic protective layer is established, of which the thickness can easily be controlled.

According to a preferred embodiment of the invention, the controllable voltage source is at one end connected to the at least one mirror and on at an other end connected to an electrode facing the mirror. Such an apparatus will generate a reliable way of adjusting the potential of the reflective surface of the mirror. The electrode can have all kinds of shaped, such as a shape that resembles the shape and dimensions of the mirror. Alternatively, the electrode could also be a ring-shaped wire, a straight wire or a point source or any other suitable shape.

According to a further preferred embodiment of the invention, the controllable voltage source is at one end connected to the at least one mirror and at an other end connected to earth. This is an easy and cost effective way of applying a potential to the surface.

According to a further preferred embodiment of the invention, the apparatus comprises means for monitoring a background pressure in the chamber containing the at least one mirror. This enables to control the amount of gas in the chamber, and thus the growing speed of the protective layer, in a more accurate way.

According to a further aspect of the invention, the invention relates to a lithographic projection apparatus comprising:
- a radiation system for providing a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate, characterized in that the lithographic projection apparatus further comprises an apparatus according to the invention.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
- Figure 1 depicts a lithographic projection apparatus according to an embodiment of the invention;
- Figure 2 depicts a mirror in a low pressure environment subjected to EUV radiation;
- Figure 3 depicts a mirror according to an embodiment of the present invention;
- Figure 4 depicts a chamber containing mirrors according to an embodiment of the present invention;
- Figure 5 depicts a chamber containing mirrors according to a further embodiment of the present invention.

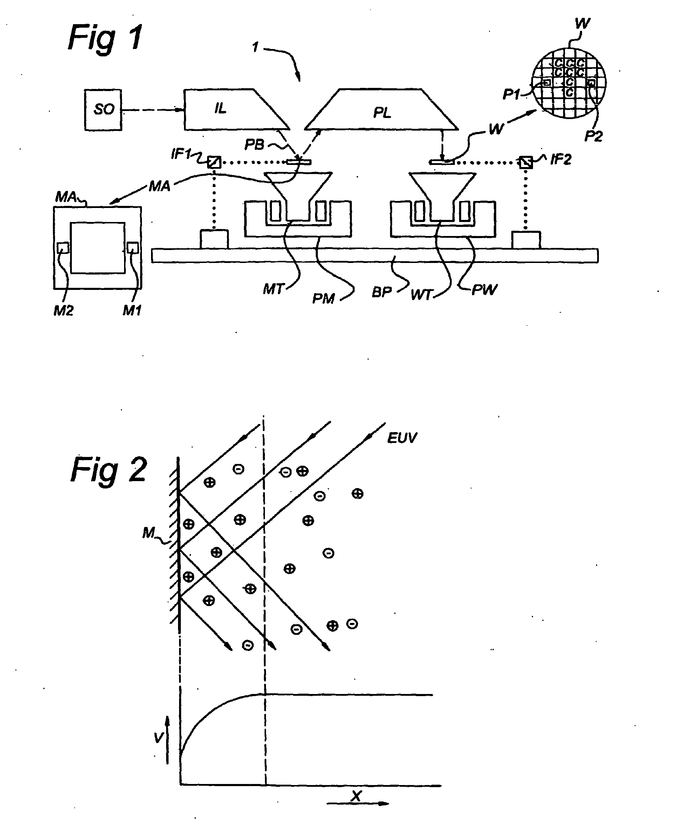

Figure 1 schematically depicts a lithographic apparatus according to a particular embodiment of the invention. The apparatus comprises:
- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF 1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

As already discussed above, in case EUV radiation is used, mirrors M are used to project the projection beam PB. In that case it is observed that a plasma is formed in front of the mirrors M as a result of the EUV-radiation in low pressure Argon or other gasses present in the chamber containing one or more mirrors M of the lithographic projection apparatus 1. The existence of this plasma has experimentally been confirmed as a glow in the collected EUV bundle.

The plasma comprises electrons and positive ions. When these particles collide with the surface of one of the mirrors M, these particles are absorbed. However, since the electrons travel faster than the positive ions, an electric field is generated over a distance that corresponds with the Debije length, as will be understood by a person skilled in the art. Fig 2 schematically shows the distribution of electrons and positive ions in the vicinity of the mirror M. The lower part of Fig. 2 schematically shows the potential V as a function of the distance x from the mirror M.

It can be seen in Fig. 2 that an electric field exists in the vicinity of the mirror M, directed perpendicular to the surface of the mirror M. This electric field accelerates the positive ions towards the surface of the mirror M. When these ions hit the surface of the mirror M, the surface of the mirror M is damaged, i.e. the ions etch the surface of the mirror M. This has a negative effect on the reflectivity of the mirror M.

In EP 1 186 957 a dynamic protective layer was presented. The thickness of the protective layer was controlled by two competitive processes at the surface of the mirror. The first was the growth of the protective layer due to CₓH_{y} contamination, regulated by controlling the pressure of a hydrocarbon gas. The second process is the etching of the surface of the mirror by fast incoming ions coming from the source. The thickness of the protective layer is controlled by adjusting the pressure of the hydrocarbon gas.

According to the present invention, a gas pressure is maintained for providing a protective layer due to CₓH_{y} contamination, by controlling the plasma induced etching.

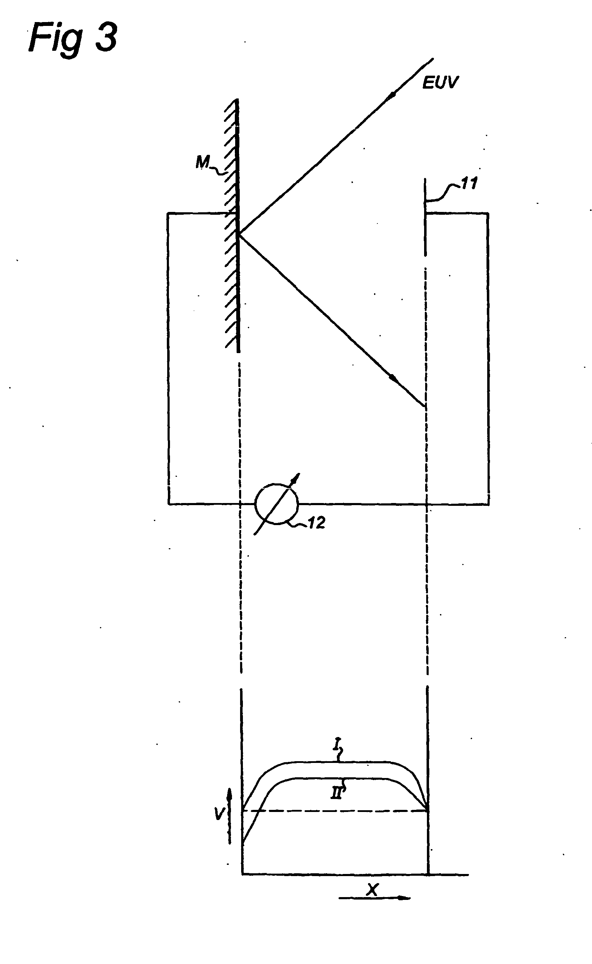

Fig. 3 shows an example of a mirror M according to an embodiment of the invention. The figure shows an electrode 11 facing the surface of the mirror M. The mirror M and the electrode 11 are both connected to an adjustable voltage source 12. In the lower part of Fig. 3 the potential V is depicted as a function of the distance from the surface of the mirror M towards the electrode. The curve indicated by I shows the potential V in case the adjustable voltage source 12 is set to zero. If, however, the adjustable voltage source 12 is set to a value different from zero, the potential V in the vicinity of the mirror M is altered. For instance, if a negative voltage is applied to the mirror M relative to the electrode 11, the electric field E will look like the curve in the lower part of Fig. 3 indicated by II, showing a higher potential difference between the mirror M and the centre of the plasma. It will be understood that in that case, the positive ions will be accelerated to a higher velocity and the etching of the mirror M will increase. Of course, the etching can also be decreased by applying a positive voltage to the surface of the mirror M with respect to the electrode 11.

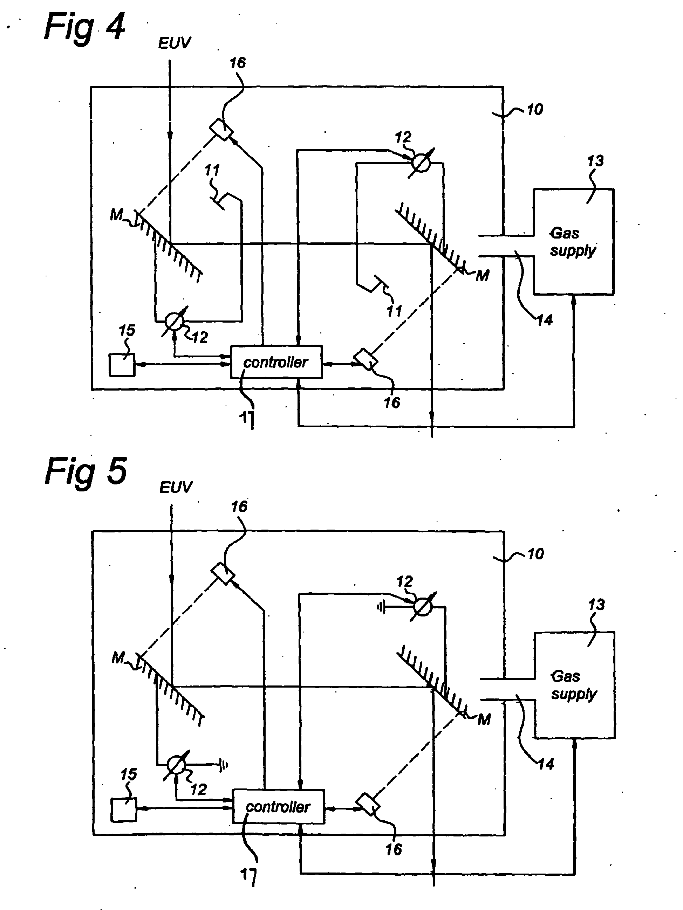

Fig. 4 shows a chamber 10 comprising two mirrors M that are both connected to an adjustable voltage source 12 according to Fig. 3. Fig. 4 shows only two mirrors, but of course any other suitable number of mirrors M can be used. If the mirrors M are used to project a pattern beam PB to a substrate W, usually 6 mirrors are used. Further on, the mirrors M can be provided with actuators (not shown) to control their orientation.

Fig. 4 further shows an inlet 14 connected to a gas supply 13. The gas supply 13 provides the chamber 10 with, e.g., a hydrocarbon gas. Hydrocarbon molecules adsorb to the surface of the mirror M, forming a protective layer on the surface of the mirror M, as already discussed above. The amount of gas in the chamber 10 determines the speed of the growth of the protective layer. In order to ensure a constant growth of the protective layer, a sensor 15 is provided in the chamber 10 that measures the amount of hydrocarbon in the chamber. If the amount of hydrocarbon is kept constant, a constant growth can be assumed. The sensor is connected to a controller 17, that is also connected to gas supply 13. The controller 17 controls the amount of hydrocarbon in chamber 10 via gas supply 13 based on a sensor signal from sensor 15.

At the same time, the protective layer is gradually eroded as a result of plasma induced etching. If this erosion of the protective layer is in equilibrium with the growth of the protective layer, a constant thickness of the protective layer is established. Since the protective layer reduces the reflectivity of the mirror M, the thickness of the protective layer can be measured by measuring the reflectivity of the mirror M. The reflectivity may, for instance, be measured by measuring the light intensity of incoming and reflected light of a certain mirror M and determining the ratio between these two measured values. Many types of sensors for measuring reflectivity are known to a person skilled in the art. Fig. 4 shows such a reflectivity sensor 16 for each of the mirrors M in schematic form. The dotted line towards mirror M indicates a beam for measuring reflectivity. The sensors 16 are connected to controller 17 that is also connected to the adjustable voltage sources 12. Based on the measured reflectivity by the sensors 16 each adjustable voltage source 12 can be separately controlled by controller 17 to provide mirror M with a desired voltage V, in order to increase or decrease the amount of etching. If the determined reflectivity is in accordance with a desired reflectivity, the setting of the adjustable voltage source 12 should not be altered by controller 17.

The protective layer can be kept at a certain thickness that provides sufficient protection of the mirror M and does not reduce the reflectivity of the mirror too much.

Before use, the mirror can already be provided with an initial protective protective layer. In use, the thickness of the protective layer can be maintained by the mechanism described above.

The electrode 11 can have all kind of shapes. For instance, the electrode 11 can be a plate having a similar shape and dimensions as the mirror M. Alternatively, the electrode 11 can be a ring-shaped wire, a straight wire or a point source or may have any other suitable shape.

Many different hydrocarbon (HₓC_{Y}) gasses are suitable for use in this invention. Examples of suitable gasses are acetic anhydride, n-amyl alcohol, amyl benzoate, diethylene glycol ethyl ether, acrylic acid, adipic acid, 2-tert-butyl-4-ethylphenol.

It will be understood that the etching rate of the protective layer is not only determined by the voltage difference between the plasma and the mirror surface. Also, the characteristics of the hydrocarbon molecules used is important. For instance, bigger ions will etch the protective layer or the mirror M more effectively.

Fig. 5 depicts a further embodiment of the invention. Same reference numbers for similar objects are used as in Fig. 4. In this embodiment, the adjustable voltage source 12 is at one side connected to the mirror M, and is grounded on the other side. No electrodes 11 are provided. It will be understood that in general, applying a negative voltage to the mirrors M is sufficient to control plasma induced etching. Of course, it is also possible to apply a positive voltage to the surroundings, such as the surrounding walls.

It has to be understood that the voltage applied to the mirrors M can not be used to simply cancel the voltage difference that occurs at the borders of the plasma. This is due to the fact that the processes that occur are non-stationary and strongly time dependent, as will be understood by a person skilled in the art.

According to a further embodiment of the invention, one or more electrodes 11 can be formed as a mesh (not shown). Using a mesh helps creating a well defined voltage drop between the mirror M and the electrode 11.

Whilst specific embodiments of the invention have been described above, it will be appreciated that the invention may be practiced otherwise than as described. The description is not intended to limit the invention.

## Claims

1. Method of supplying a dynamic protective layer to at least one mirror (M) to protect the at least one mirror (M) from etching by ions, the method comprising
- supplying a gaseous matter to a chamber (10) containing the at least one mirror (M),
- monitoring reflectivity of the mirror (M),
**characterized in, that** the thickness of the protective layer is controlled by controlling a potential of the surface of the mirror (M), based on the monitored reflectivity of the mirror (M).

2. Method according to claim 1, wherein the gas is a gaseous hydrocarbon (HₓC_{y}), such as acetic anhydride, n-amyl alcohol, amyl benzoate, diethylene glycol ethyl ether, acrylic acid, adipic acid, 2-tert-butyl-4-ethylphenol.

3. Method according to any one of the preceding claims, wherein the at least one mirror (M) is used to image a mask (MA) to a substrate (W).

4. Method according to any one of the preceding claims, wherein the at least one mirror (M) is used to project an EUV radiation beam.

5. Method according to any one of the preceding claims, wherein said chamber (10) has a background pressure that is monitored.

6. A device manufacturing method comprising:
- providing a substrate (W) that is at least partially covered by a layer of radiation-sensitive material;
- providing a projection beam (PB) of radiation using a radiation system;
- using patterning means (MA) to endow the projection beam (PB) with a pattern in its cross-section; and
- projecting the patterned beam (PB) of radiation onto a target portion (C) of the layer of radiation-sensitive material,
**characterized by** applying the method according to any one of the claims 1 - 5.

7. Apparatus for supplying a dynamic protective layer to at least one mirror (M) to protect the at least one mirror (M) from etching by ions, the apparatus comprising a chamber (10) with the at least one mirror (M), an inlet (14) for supplying a gaseous matter to the chamber (10) containing the at least one mirror (M) and means (16) for monitoring reflectivity of the mirror (M),
**characterized in that**, the apparatus further comprises a controllable voltage source (12) for applying a potential (V) to the surface of the mirror (M) in order to control the thickness of the protective layer in dependence on said reflectivity of said mirror (M).

8. Apparatus according to claim 7, wherein the controllable voltage source (12) is at one end connected to the at least one mirror (M) and on at an other end connected to an electrode (11) facing the mirror (M).

9. Apparatus according to claim 7, wherein the controllable voltage source (12) is at one end connected to the at least one mirror (M) and at an other end connected to earth.

10. Apparatus according to any one of the claims 7-9, comprising means (15) for monitoring a background pressure in the chamber (10) containing the at least one mirror (M).

11. Apparatus according to claim 8, wherein the electrode has a configuration selected from the group comprising: plates of similar shape and dimensions as said mirror, ring-shaped wires, straight wires, meshes and point sources.

12. A lithographic projection apparatus comprising:
- a radiation system for providing a projection beam (PB) of radiation;
- a support structure (MT) for supporting patterning means (MA), the patterning means (MA) serving to pattern the projection beam (PB) according to a desired pattern;
- a substrate table for holding a substrate (W); and
- a projection system for projecting the patterned beam (PB) onto a target portion (C) of the substrate (W),
**characterized in that** the lithographic projection apparatus further comprises an apparatus according to any of the claims 7-11.

## Patentansprüche

1. Verfahren, um mindestens einen Spiegel (M) mit einer dynamischen Schutzschicht zu versehen, um den mindestens einen Spiegel (M) vor dem Ätzen mit Ionen zu schützen, wobei das Verfahren die folgenden Schritte aufweist:
- einer Kammer (10), die den mindestens einen Spiegel (M) enthält, wird eine gasförmige Substanz zugeführt,
- das Reflexionsvermögen des Spiegels (M) wird überwacht,
**dadurch gekennzeichnet,**
**daß** die Dicke der Schutzschicht gesteuert wird, indem ein Potential der Oberfläche des Spiegels (M) auf der Basis des überwachten Reflexionsvermögens des Spiegels (M) gesteuert wird.

2. Verfahren nach Anspruch 1,
wobei das Gas ein gasförmiger Kohlenwasserstoff (HₓC_{y}) ist, wie etwa Essigsäureanhydrid, n-Amylalkohol, Amylbenzoat, Diethylenglycolethylether, Acrylsäure, Adipinsäure, 2-tert.-Butyl-4-ethylphenol.

3. Verfahren nach einem der vorhergehenden Ansprüche,
wobei der mindestens eine Spiegel (M) dazu verwendet wird, eine Maske (MA) auf einem Substrat (W) abzubilden.

4. Verfahren nach einem der vorhergehenden Ansprüche,
wobei der mindestens eine Spiegel (M) dazu verwendet wird, einen Strahl aus EUV-Strahlung zu projizieren.

5. Verfahren nach einem der vorhergehenden Ansprüche,
wobei die Kammer (10) einen Hintergrunddruck hat, der überwacht wird.

6. Verfahren zum Herstellen einer Vorrichtung,
das die folgenden Schritte aufweist:
- ein Substrat (W), das mindestens teilweise mit einer Schicht aus strahlungsempfindlichem Material bedeckt ist, wird bereitgestellt;
- ein Projektionsstrahl (PB) einer Strahlung wird unter Verwendung eines Strahlungssystems bereitgestellt;
- eine Strukturierungseinrichtung (MA) wird verwendet, um dem Projektionsstrahl (PB) in seinem Querschnitt eine Struktur (PB) zu geben; und
- der strukturierte Strahl (PB) von Strahlung wird auf einen Zielbereich (C) der Schicht aus strahlungsempfindlichem Material projiziert,
**gekennzeichnet durch**
die Verwendung des Verfahrens nach einem der Ansprüche 1 bis 5.

7. Vorrichtung, um mindestens einen Spiegel (M) mit einer dynamischen Schutzschicht zu versehen, um den mindestens einen Spiegel (M) vor dem Ätzen mit Ionen zu schützen, wobei die Vorrichtung folgendes aufweist: eine Kammer (10) mit dem mindestens einen Spiegel (M), einen Einlaß (14), um der den mindestens einen Spiegel (M) enthaltenden Kammer (10) eine gasförmige Substanz zuzuführen, und eine Einrichtung (16) zum Überwachen des Reflexionsvermögens des Spiegels (M),
**dadurch gekennzeichnet,**
**daß** die Vorrichtung ferner eine steuerbare Spannungsquelle (12) zum Anlegen eines Potentials (V) an die Oberfläche des Spiegels (M) aufweist, um die Dicke der Schutzschicht in Abhängigkeit von dem Reflexionsvermögen des Spiegels (M) zu steuern.

8. Vorrichtung nach Anspruch 7,
wobei die steuerbare Spannungsquelle (12) an dem einen Ende mit dem mindestens einen Spiegel (M) verbunden ist und an einem anderen Ende mit einer Elektrode (11) verbunden ist, die dem Spiegel (M) zugewandt ist.

9. Vorrichtung nach Anspruch 7,
wobei die steuerbare Spannungsquelle (12) an dem einen Ende mit dem mindestens einen Spiegel (M) verbunden ist und an einem anderen Ende mit Masse verbunden ist.

10. Vorrichtung nach einem der Ansprüche 7 bis 9,
die eine Einrichtung (15) zum Überwachen des Hintergrunddrucks in der den mindestens einen Spiegel (M) enthaltenden Kammer (10) aufweist.

11. Vorrichtung nach Anspruch 8,
wobei die Elektrode eine Konfiguration hat, die aus der Gruppe gewählt ist, die folgendes aufweist: Platten mit ähnlicher Gestalt und ähnlichen Dimensionen wie der Spiegel, ringförmige Drähte, gerade Drähte, Gitter und Punktquellen.

12. Lithographische Projektionsvorrichtung,
die folgendes aufweist:
- ein Strahlungssystem zum Bereitstellen eines Projektionsstrahls (PB) einer Strahlung;
- eine Tragkonstruktion (MT) zur Halterung von einer Strukturierungseinrichtung (MA), wobei die Strukturierungseinrichtung (MA) dazu dient, den Projektionsstrahl (PB) gemäß einer gewünschten Struktur zu strukturieren;
- einen Substrattisch zum Halten eines Substrats (W); und
- ein Projektionssystem zum Projizieren des strukturierten Strahls (PB) auf einen Zielbereich (C) des Substrats (W),
**dadurch gekennzeichnet,**
**daß** die lithographische Projektionsvorrichtung ferner eine Vorrichtung nach einem der Ansprüche 7 bis 11 aufweist.

## Revendications

1. Procédé de fourniture d'une couche protectrice dynamique sur au moins un miroir (M) pour protéger le au moins un miroir (M) de l'attaque par des ions, le procédé comprenant :
- la fourniture d'une matière gazeuse à une chambre (10) renfermant le au moins un miroir (M),
- le contrôle de la réflectivité du miroir (M),
**caractérisé en ce que** l'épaisseur de la couche protectrice est régulée en régulant un potentiel de la surface du miroir (M), calculé sur la réflectivité contrôlée du miroir (M).

2. Procédé selon la revendication 1, dans lequel le gaz est un hydrocarbure gazeux (HₓC_{y}) comme de l'anhydride acétique, de l'alcool n-amylique, du benzoate d'amyle, de l'éther éthylique de diéthylène glycol, de l'acide acrylique, de l'acide adipique, du 2-tert-butyl-4-éthylphénol.

3. Procédé selon l'une quelconque des revendications précédentes, dans lequel le au moins un miroir (M) est utilisé pour imager un masque (MA) sur un substrat (W).

4. Procédé selon l'une quelconque des revendications précédentes, dans lequel le au moins un miroir (M) est utilisé pour projeter un faisceau de rayonnements EUV.

5. Procédé selon l'une quelconque des revendications précédentes, dans lequel ladite chambre (10) a une pression de fond qui est contrôlée.

6. Procédé de fabrication d'un dispositif comprenant :
- la fourniture d'un substrat (W) qui est au moins partiellement recouvert par une couche de matériau sensible aux rayonnements ;
- la fourniture d'un faisceau de projection (PB) de rayonnement utilisant un système de rayonnements ;
- l'utilisation d'un moyen de formation de motifs (MA) pour doter le faisceau de projection (PB) d' un motif dans sa section transversale ; et
- la projection d'un faisceau à motif (PB) de rayonnement sur une partie cible (C) de la couche de matériau sensible aux rayonnements,
**caractérisé par** l'application du procédé selon l'une quelconque des revendications 1 à 5.

7. Appareil pour fournir une couche protectrice dynamique sur au moins un miroir (M) pour protéger le au moins un miroir (M) de l'attaque par des ions, l'appareil comprenant une chambre (10) avec au moins un miroir (M), une entrée (14) pour amener une matière gazeuse à la chambre (10) renfermant le au moins un miroir (M) et un moyen (16) pour contrôler la réflectivité du miroir (M), **caractérisé en ce que** l'appareil comporte, en outre, une source de tension apte à être régulée (12) pour appliquer un potentiel (V) à la surface du miroir (M) afin de réguler l'épaisseur de la couche protectrice en fonction de ladite réflectivité dudit miroir (M).

8. Appareil selon la revendication 7, dans lequel la source de tension apte à être régulée (12) est à une extrémité reliée à au moins un miroir (M) et sur une autre extrémité reliée à une électrode (11) en vis-à-vis du miroir (M).

9. Appareil selon la revendication 7, dans lequel la source de tension apte à être régulée (12) est à une extrémité reliée à le au moins un miroir (M) et à une autre extrémité est reliée à la terre.

10. Appareil selon l'une quelconque des revendications 7 à 9, comprenant un moyen (15) pour réguler une pression de fond dans la chambre (10) renfermant le au moins un miroir (M).

11. Appareil selon la revendication 8, dans lequel l'électrode présente une configuration choisie dans le groupe comprenant des plaques de forme et de dimensions analogues comme ledit miroir, des fils en forme d'anneau, des fils droits, des treillis et des sources de point.

12. Appareil de projection lithographique comprenant :
- un système de rayonnements pour fournir un faisceau de projection (PB) de rayonnement ;
- une structure de support (MT) pour supporter un moyen à motif (MA), le moyen à motif (MA) servant à configurer le faisceau de projection (PB) selon un motif souhaité ;
- un support de substrat pour maintenir un substrat (W) ; et
- un système de projection pour projeter le faisceau à motif (PB) sur une partie cible (C) du substrat (W),
**caractérisé en ce que** l'appareil de projection lithographique comprend, en outre, un appareil selon l'une quelconque des revendications 7 à 11.
